(19) Europäisches Patentamt
European Patent Office
Office européen des brevets

(11) **EP 1 944 872 B1**

(12) **EUROPEAN PATENT SPECIFICATION**

(45) Date of publication and mention
of the grant of the patent:
**19.06.2013 Bulletin 2013/25**

(51) Int Cl.:
*H03D 1/22* *(2006.01)*    *H03G 3/30* *(2006.01)*
*H04B 1/28* *(2006.01)*    *H04L 27/06* *(2006.01)*
*H04L 27/08* *(2006.01)*

(21) Application number: **06811694.6**

(22) Date of filing: **12.10.2006**

(86) International application number:
**PCT/JP2006/320406**

(87) International publication number:
**WO 2007/052456 (10.05.2007 Gazette 2007/19)**

(54) **AM RECEIVING APPARATUS AND AM RECEIVING METHOD**

AM-EMPFANGSVORRICHTUNG UND AM-EMPFANGSVERFAHREN

APPAREIL ET PROCEDE DE RECEPTION AM

(84) Designated Contracting States:
**DE FR GB**

(30) Priority: **31.10.2005   JP 2005317018**

(43) Date of publication of application:
**16.07.2008   Bulletin 2008/29**

(73) Proprietor: **Pioneer Corporation
Kanagawa 212-0031 (JP)**

(72) Inventor: **KUBUKI, Toshiaki
Kawagoe-shi
Saitama 350-8555 (JP)**

(74) Representative: **Sajda, Wolf E. et al
Meissner, Bolte & Partner GbR
Postfach 86 06 24
81633 München (DE)**

(56) References cited:
EP-A2- 0 722 235       GB-A- 2 297 442
JP-A- 04 100 325       JP-A- 2005 027 171
JP-A- 2005 057 675     US-A- 5 600 328

**Description**

TECHNICAL FIELD

The present invention relates to an AM receiver and an AM reception method for receiving, for example, AM radio broadcasts and the like.

BACKGROUND ART

For radio broadcasting and the like, the amplitude modulation (AM) scheme is employed for transmission of information. A known AM receiver is for example described in EP 0 722 235 A2.

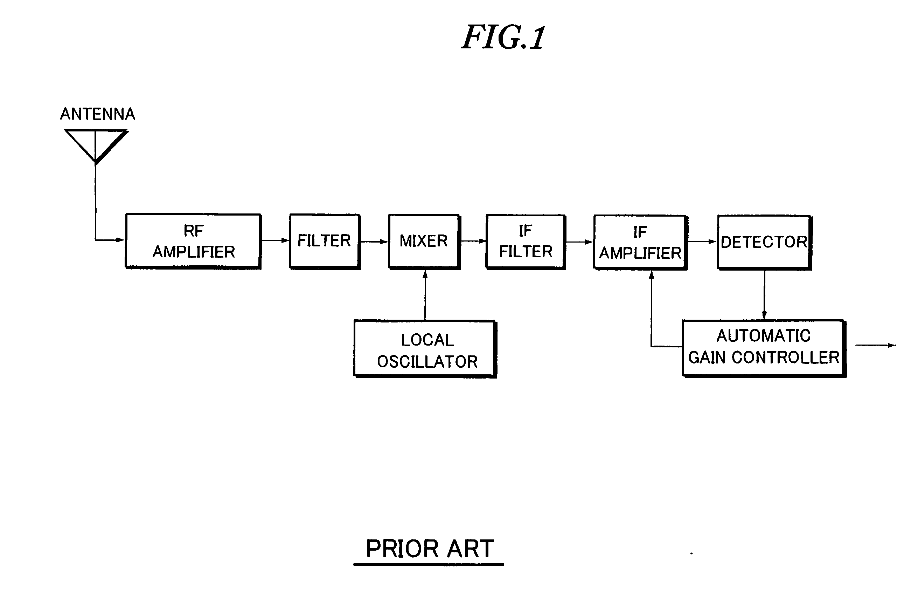

Fig. 1 is a block diagram illustrating the configuration of a typical conventional superheterodyne AM receiver. This AM receiver includes: an RF amplifier for amplifying RF signals received from an antenna; a filter for suppressing undesired signals; a frequency conversion section, made up of a mixer and a local oscillator, for conversion into intermediate frequencies (IF); an intermediate frequency band pass filter for extracting required intermediate frequency components; an intermediate frequency amplifier; a detector; and an automatic gain controller. The AM receiver is designed to provide automatic gain control to a detected signal which has been envelope detected at the detector, thereby generating a detected signal that is not affected by variations in transmission paths (see Non-Patent Document 1).
On the other hand, also known as a detection scheme that can take the place of the envelope detection is a synchronous detection scheme, which typically employs a phase locked loop (PLL) circuit to synchronously regenerate a carrier in synchronization with the frequency and phase of a received signal carrier.
Non-Patent Document 1: "NHK Radio Technical Textbook (AM/FM/PCM)" edited by Japan Broadcasting Corporation and published by Japan Broadcast Publishing Co., Ltd., 1993, pp. 201-220.

DISCLOSURE OF THE INVENTION

PROBLEMS THAT THE INVENTION IS TO SOLVE

In general, the aforementioned conventional synchronous detection AM receiver employs a PLL circuit. The PLL circuit is likely to cause a delay in tracking phase variations in transmission paths or the like, and may be difficult to synchronize an amplitude-modulated and phase-modulated signal such as AM stereo broadcast waves.
Furthermore, abrupt variations in signal strength could not be sufficiently tracked when the conventional automatic gain controller was used to feed a direct-current component contained in a detected signal as a gain control signal back to the intermediate frequency amplifier.
Furthermore, although the conventional envelope detection AM receiver has an advantage that carriers need not to be recovered, it has also a disadvantage that, when a detected direct-current component resulting from a carrier is superimposed on a detected signal and the component is to be separated therefrom, this likely causes the detected signal to be distorted. Additionally, digital signal processing detection requires a sufficiently high sampling frequency in order to improve detection efficiency, and this causes a decrease in system efficiency.
The present invention was developed in view of the aforementioned conventional problems. It is therefore an object of the invention to provide an AM receiver which can quickly track phase variations or variations in signal strength and reduce distortion of detected signals.

MEANS FOR SOLVING THE PROBLEMS

The invention according to claim 1 provides an AM receiver which regenerates a detected signal from an AM modulated signal. The AM receiver includes: orthogonal signal generation means for generating an in-phase component and an orthogonal component from the AM modulated signal; first carrier regeneration means for regenerating an in-phase carrier signal from the in-phase component; second carrier regeneration means for regenerating an orthogonal carrier signal from the orthogonal component; and detection processing means for generating a detected signal from the in-phase component and the orthogonal component by detecting the in-phase component and the orthogonal component with the in-phase carrier signal and the orthogonal carrier signal, respectively. The AM receiver is characterized in that the detection processing means comprise: first carrier elimination means for eliminating an in-phase carrier component contained in the in-phase component and for generating an in-phase carrier eliminated signal as an in-phase detected signal; and second carrier elimination means for eliminating an orthogonal carrier component contained in the orthogonal component and for generating an orthogonal carrier eliminated signal as an orthogonal detected signal,

wherein the detection processing means detect the in-phase detected signal and the orthogonal detected signal with the in-phase carrier signal and the orthogonal carrier signal, respectively.

Another AM receiver may comprise detection means for detecting a detected signal from an AM modulated signal and automatic gain control means for providing gain control to the detected signal. The automatic gain control means include: orthogonal signal generation means for generating an in-phase component and an orthogonal component from the AM modulated signal; first carrier regeneration means for regenerating an in-phase carrier signal from the in-phase component; second carrier regeneration means for regenerating an orthogonal carrier signal from the orthogonal component; and strength signal generation means for detecting a signal strength of the in-phase carrier signal and the orthogonal carrier signal and for generating a strength signal indicative of the signal strength detected. The automatic gain control means provides the gain control to the detected signal according to the strength signal.

The invention according to claim 3 provides an AM reception method for regenerating a detected signal from an AM modulated signal. The method comprises the following steps: an orthogonal signal generation step for generating an in-phase component and an orthogonal component from the AM modulated signal; a first carrier regeneration step for regenerating an in-phase carrier signal from the in-phase component; a second carrier regeneration step for regenerating an orthogonal carrier signal from the orthogonal component; and an operational detection step for generating a detected signal from the in-phase component and the orthogonal component by detecting the in-phase component and the orthogonal component with the in-phase carrier signal and the orthogonal carrier signal, respectively. The method is characterized by eliminating an in-phase carrier component contained in the in-phase component; generating an in-phase carrier eliminated signal (SRI) as an in-phase detected signal; eliminating an orthogonal carrier component contained in the orthogonal component; generating an orthogonal carrier eliminated signal as an orthogonal detected signal; and detecting the in-phase detected signal and the orthogonal detected signal with the in-phase carrier signal and the orthogonal carrier signal, respectively.

Another AM reception method for providing gain control to a detected signal which has been detected from an AM modulated signal may comprises the following steps: an orthogonal signal generation step for generating an in-phase component and an orthogonal component from the AM modulated signal; a first carrier regeneration step for regenerating an in-phase carrier signal from the in-phase component; a second carrier regeneration step for regenerating an orthogonal carrier signal from the orthogonal component; and a strength signal generation step for detecting a signal strength of the in-phase carrier signal and the orthogonal carrier signal and for generating a strength signal indicative of the signal strength detected. In the method, the gain control is provided to the detected signal according to the strength signal.

BRIEF DESCRIPTION OF THE DRAWINGS

Fig. 1    is a block diagram illustrating the configuration of a conventional AM receiver;
Fig. 2    is a block diagram illustrating the configuration of an AM receiver according to a first embodiment;
Fig. 3    is a block diagram illustrating the configuration of an AM receiver according to a second embodiment;
Fig. 4    is a block diagram illustrating the entire configuration of an AM receiver according to an example; and
Fig. 5    is a block diagram illustrating the configuration of a detection section and an automatic gain adjustment section shown in Fig. 4.

BEST MODE FOR CARRYING OUT THE INVENTION

First embodiment

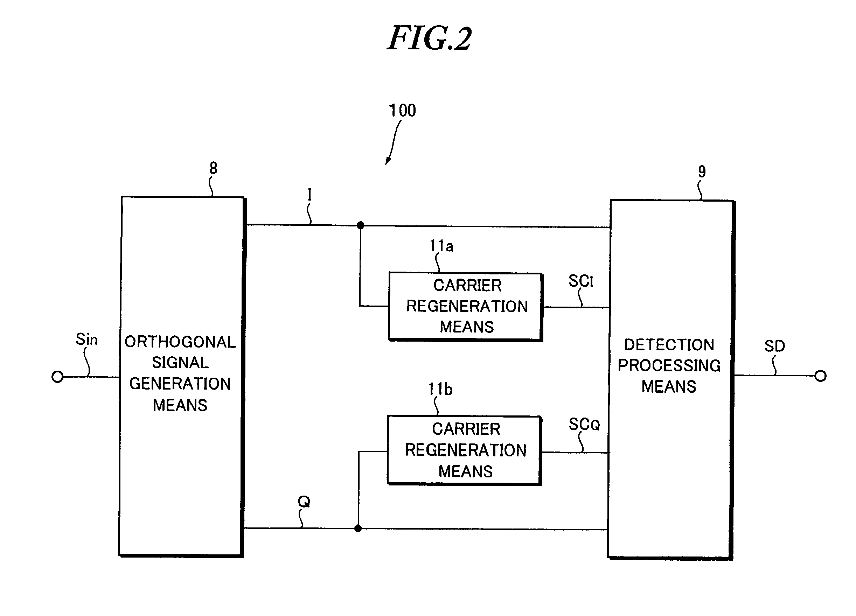

With reference to Fig. 2, a description will now be made to an AM receiver according to a first embodiment of the present invention.

As shown in the block diagram of Fig. 2, this AM receiver includes orthogonal signal generation means 8, detection processing means 9, and carrier regeneration means 11a and 11b, all of which constitute a detection apparatus 100. The AM receiver generates a detected signal SD based on an AM modulated signal Sin delivered from a front end section (not shown) and then outputs the detected signal SD.

Here, the orthogonal signal generation means 8 receives the AM modulated signal Sin from the aforementioned front end section and allows a predetermined generation process to generate an in-phase component I and an orthogonal component Q, which have carrier components that are orthogonal to each other.

The carrier regeneration means 11 a and 11 b extract the in-phase and orthogonal carrier components from the in-phase component I and the orthogonal component Q to regenerate carrier signals $SC_I$ and $SC_Q$, respectively.

The detection processing means 9 receives the in-phase component I and the orthogonal component Q from the orthogonal signal generation means 8, and the in-phase and orthogonal carrier signals $SC_I$ and $SC_Q$ from the respective carrier regeneration means 11a and 11b. The detection processing means 9 performs an operational detection on the in-phase component I and the orthogonal component Q using the carrier signals $SC_I$ and $SC_Q$, respectively, to thereby generate the detected signal SD.

A description will now be made to the operation of the detection apparatus 100.

The AM modulated signal Sin is delivered from the front end section (not shown) to the orthogonal signal generation means 8. Then, from the AM modulated signal Sin, the orthogonal signal generation means 8 generates two AM modulated signals having carrier components that are orthogonal to each other, or the in-phase component I and the orthogonal component Q, for output to the carrier regeneration means 11a and 11b and the detection processing means 9. The carrier regeneration means 11a and 11b generate the carrier signals $SC_I$ and $SC_Q$ from the in-phase component I and the orthogonal component Q for output to the detection processing means 9. The detection processing means 9 performs the operational detection on the in-phase component I and the orthogonal component Q from the orthogonal signal generation means 8 using the carrier signals $SC_I$ and $SC_Q$ from the carrier regeneration means 11a and 11b to generate the detected signal SD.

According to the AM receiver of the present embodiment which includes the detection apparatus 100 described above, the following effects can be obtained.

The AM receiver allows the carrier regeneration means to provide feedforward and thereby directly regenerate carrier signals from the in-phase component I and the orthogonal component Q, which have carrier components that are orthogonal to each other, without using carrier sync means such as a PLL. It is thus possible to quickly track even an abrupt phase variation of a received AM modulated signal in a transmission path or the like, and thus provide quick responsivity and good trackability to generate detected signals.

Second embodiment

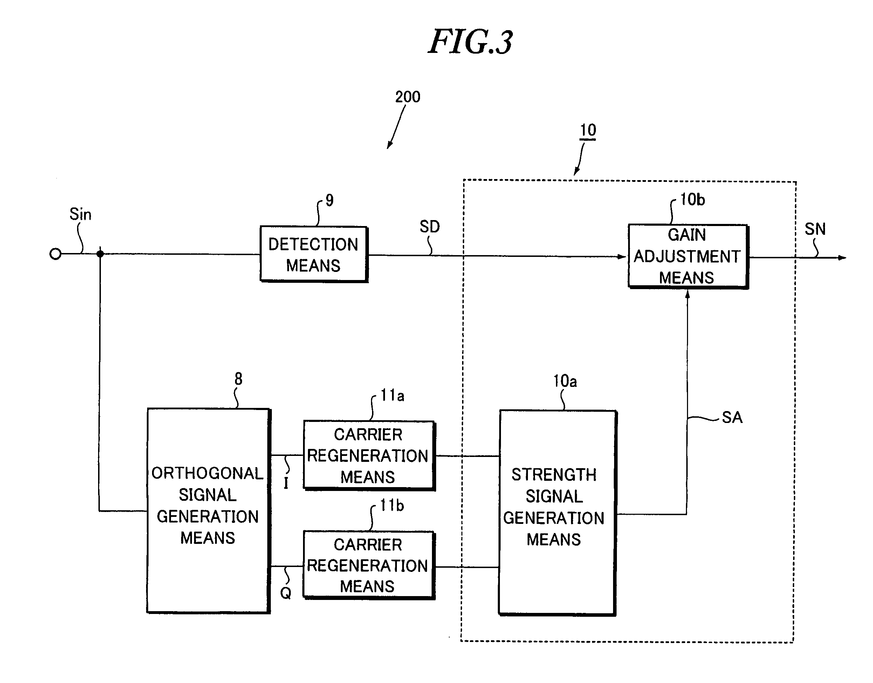

With reference to Fig. 3, a description will now be made to an AM receiver according to a second embodiment. Fig. 3 is a block diagram illustrating the AM receiver of the present embodiment.

In Fig. 3, an AM receiver 200 is configured to include the orthogonal signal generation means 8, the detection means 9, the carrier regeneration means 11a and 11b, and automatic gain control means 10. The automatic gain control means 10 is configured to include strength signal generation means l0a and gain adjustment means 10b.

As in the first embodiment, the orthogonal signal generation means 8 receives the AM modulated signal Sin from the front end section (not shown), and allows a predetermined generation process to generate the in-phase component I and the orthogonal component Q, which have carrier components that are orthogonal to each other.

The detection means 9 detects the input signal Sin to thereby generate the detected signal SD. Note that the detection means 9 has only to have a typical detection function and may employ either an envelope detection scheme or a synchronous detection scheme.

The carrier regeneration means 11 a and 11b extract the in-phase and orthogonal carrier components from the in-phase component I and the orthogonal component Q to regenerate the carrier signals $SC_I$ and $SC_Q$, respectively.

The strength signal generation means 10a generates from the carrier signals $SC_I$ and $SC_Q$ a strength signal SA required for gain control and then supplies it to the gain adjustment means 10b.

The gain adjustment means 10b uses the strength signal SA to provide gain control to the detected signal SD and thereby generates a gain-controlled detected signal SN which is independent of the signal strength of the AM modulated signal Sin.

A description will now be made to the operation of the AM receiver 200.

When the AM modulated signal Sin is delivered from the front end section (not shown) to the detection means 9 and the orthogonal signal generation means 8, the detection means 9 allows the detection function to generate the detected signal SD.

As in the first embodiment, from the AM modulated signal Sin, the orthogonal signal generation means 8 generates two AM modulated signals having carrier components that are orthogonal to each other, or the in-phase component I and the orthogonal component Q, for output to the carrier regeneration means 11a and 11b. The carrier regeneration means 11a and 11b extract the carrier components, which are contained in the in-phase component I and the orthogonal component Q, to thereby generate the carrier signals $SC_I$ and $SC_Q$, respectively, for delivery to the strength signal generation means 10a.

The strength signal generation means 10a uses each of the carrier signals $SC_I$ and $SC_Q$ to generate the strength signal SA for making gain adjustments. Using the strength signal SA, the gain adjustment means 10b provides gain control to the detected signal SD to generate an automatically gain-controlled detected signal SN.

The AM receiver 200 according to the second embodiment described above can provide the following effects.

The AM receiver 200 uses no carrier regeneration and sync means that includes a feedback circuit such as a PLL. Instead, the AM receiver 200 allows the carrier regeneration means to provide feedforward and thereby directly regenerate carrier signals from the in-phase component I and the orthogonal component Q. The AM receiver 200 also allows the automatic gain control means to provide feedforward and thereby directly generate a strength signal required for gain control from the carrier signals. Providing feedforward in this manner makes it possible to quickly track an abrupt strength variation of a received modulated signal, allowing for providing gain control to generate a detected signal.

First example

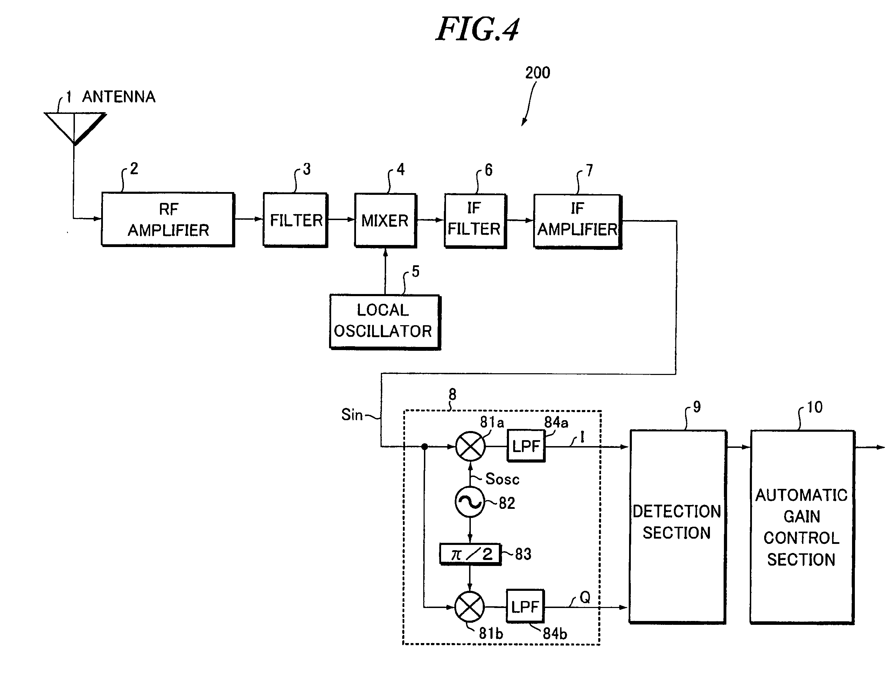

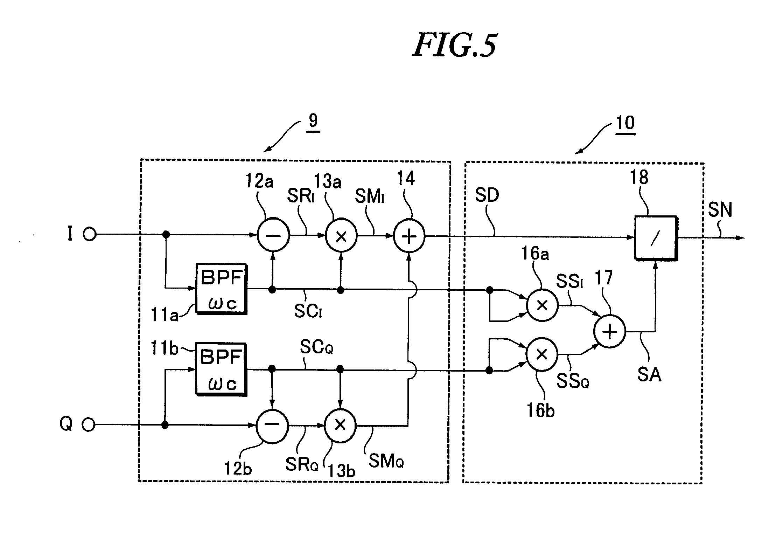

With reference to Figs. 4 and 5, a description will now be made to a more specific example. Fig. 4 is a block diagram illustrating the configuration of an AM receiver according to this example. Fig. 5 is a block diagram illustrating the configuration of a detection section and an automatic gain adjustment section. Note that in Figs. 4 and 5, those components which are the same as or equivalent to those of Fig. 2 or Fig. 3 are indicated with the same symbols.

In Fig. 4, the AM receiver 200 is configured to include a superheterodyne front end section, an orthogonal signal generation section 8, a detection section 9, and an automatic gain control section 10. Here, the front end section has a receiver antenna 1, an RF amplifier 2, a filter 3, a mixer 4, a local oscillator 5, an intermediate frequency (IF) band pass filter 6, and an intermediate frequency (IF) amplifier 7.

The orthogonal signal generation section 8 includes two mixers 81a and 81b, an oscillator 82, a 90-degree phase shifter 83, and two low-pass filters 84a and 84b, and functions to generate the in-phase component I and the orthogonal component Q from an intermediate frequency signal Sin.

The intermediate frequency signal Sin is supplied to the orthogonal signal generation section 8. Then, the intermediate frequency signal Sin is subjected to an orthogonal detection at the mixers 81a and 81b using an oscillated signal Sosc from the oscillator 82 having been set to an oscillation angular frequency $\omega osc$ and a 90-degree phase shifted signal from the 90-degree phase shifter 83 (this signal also has the oscillation angular frequency $\omega osc$). Thus, the intermediate frequency signal Sin is generated as the in-phase component I and the orthogonal component Q. Furthermore, those harmonic components that occur during the aforementioned detection are cut in the low-pass filters 84a and 84b, thereby generating the in-phase component I and the orthogonal component Q with unnecessary components eliminated.

Note that since the aforementioned oscillated signal Sosc from the oscillator 82 needs not to be synchronized with the frequency and phase of the intermediate frequency signal Sin, no synchronization circuit such as a PLL circuit including a voltage control oscillator (VCO) is not provided.

A description will now be made to the operation of the orthogonal signal generation section 8. For convenience of explanation, the description will be made assuming that the intermediate frequency signal Sin to be detected is an amplitude modulated (AM modulated) signal which is typically expressed by the following equation (1).

Equation 1

$$S\ in = A\,(1 + m\cos(pt))\cos(\omega\,in\,t) \qquad \dots(1).$$

That is, coefficient A is the amplitude value of a carrier, m is the modulation factor, p is the angular frequency of a modulated signal, and $\omega in$ is the carrier angular frequency, and the intermediate frequency signal Sin is assumed to have been AM modulated based on a modulated signal SM which is typically expressed by the following equation (2).

Equation 2

$$SM = \cos(pt) \qquad \dots(2).$$

The AM modulated signal Sin or an intermediate frequency signal is supplied to the orthogonal signal generation means 8. Then, from the AM modulated signal Sin, the orthogonal signal generation means 8 generates two AM modulated signals having carrier components that are orthogonal to each other, or the in-phase component I and the orthogonal component Q, for output to the carrier regeneration means 11a and 11b and carrier elimination means 12a and 12b. That is, the in-phase component I and the orthogonal component Q expressed by the following equations (3a) and (3b) are generated for output.

Equation 3

$$I = \quad A\,(1 + m\cos(pt))\cdot\cos(\omega ct) \qquad \dots(3a)$$

$$Q = -A (1 + mcos(pt)) \cdot sin(\omega ct) \qquad \ldots (3b)$$

Here, the relationship between the carrier angular frequency $\omega c$ of the above equations (3a) and (3b) and the carrier angular frequency $\omega in$ of the modulated signal Sin expressed by Equation (1) depends on the specific configuration of the orthogonal signal generation means 8 and is typically $\omega c \leq \omega in$. That is, if the orthogonal signal generation means 8 is formed of a $\pi/2$ phase shifter (90-degree phase shifter), then $\omega c$ is equal to $\omega in$. On the other hand, if it includes the oscillator 82 that generates the oscillated signal Sosc of the oscillation angular frequency $\omega osc$ or it has a configuration identical to that for the so-called orthogonal synchronous detection, then $\omega c = \omega in - \omega osc$.

With reference to the block diagram of Fig. 5, a description will now be made to the configuration and operation of the detection section 9 and the automatic gain control section 10.

The detection section 9 is configured to include band pass filters 11a and 11b, subtractors 12a and 12b, multipliers 13a and 13b, and an adder 14.

The band pass filters 11a and 11b with a predetermined pass bandwidth centered at an angular frequency $\omega c$ pass only the respective carrier components of the in-phase component I and the orthogonal component Q and block sideband components, thereby extracting the carrier components and regenerating the carrier signals $SC_I$ and $SC_Q$ that are orthogonal to each other.

The subtractors 12a and 12b subtract the carrier signals $SC_I$ and $SC_Q$ from the in-phase component I and the orthogonal component Q, respectively. The subtractors 12a and 12b thus generate carrier eliminated signals $SR_I$ and $SR_Q$ with the carrier components contained in the in-phase component I and the orthogonal component Q having been eliminated, respectively, and then supply the resulting signals to the multipliers 13a and 13b, respectively. That is, the subtractors 12a and 12b serve as carrier elimination means.

The multipliers 13a and 13b multiply the carrier eliminated signals $SR_I$ and $SR_Q$ by the carrier signals $SC_I$ and $SC_Q$ to thereby generate multiplication derived signals $SM_I$ and $SM_Q$, respectively, and supply the resulting signals to the adder 14.

The adder 14 adds the multiplication derived signals $SM_I$ and $SM_Q$ together to generate a detected signal SD.

Next, the automatic gain control section 10 is configured to include multipliers 16a and 16b, an adder 17, and a divider 18, and share the aforementioned band pass filters 11a and 11b.

The multipliers 16a and 16b determine the sum of squares of the carrier signals $SC_I$ and $SC_Q$ to generate computation derived signals $SS_I$ and $SS_Q$.

The adder 17 adds the computation derived signals $SS_I$ and $SS_Q$ together to generate a strength signal SA as a result of the addition. The multipliers 16a and 16b and the adder 17 function to determine the sum of squares of the carrier signals $SC_I$ and $SC_Q$ and generate the strength signal SA.

The divider 18 divides the detected signal SD by the strength signal SA to thereby provide gain control and generate a gain controlled detected signal SN.

A description will now be made to the operation of the detection section 9 and the automatic gain control section 10 which are configured in this manner.

The in-phase component I and the orthogonal component Q are supplied from the orthogonal signal generation section 8 to the band pass filters 11 a and 11 b and the subtractors 12a and 12b. Then, the band pass filters 11 a and 11b output the mutually orthogonal carrier signals $SC_I$ and $SC_Q$ expressed by the following equations (4a) and (4b) to the respective subtractors 12a and 12b and the respective multipliers 13a and 13b.

Equation 4

$$SC_I = A \cdot cos \; (\omega ct) \qquad \ldots (4a)$$

$$SC_Q = -A \cdot sin \; (\omega ct) \qquad \ldots (4b).$$

The subtractors 12a and 12b output the carrier eliminated signals $SR_I$ and $SR_Q$, expressed by the following equations (5a) and (5b), with the carrier signals $SC_I$ and $SC_Q$ subtracted from the in-phase component I and the orthogonal component Q, and supply the signals $SR_I$ and $SR_Q$ to the multipliers 13a and 13b, respectively.

Equation 5

$$SR_I = Am \cdot \cos(pt) \cdot \cos(\omega ct) \qquad \ldots(5a)$$

$$SR_Q = -Am \cdot \cos(pt) \cdot \sin(\omega ct) \qquad \ldots(5b).$$

Then, the carrier eliminated signals $SR_I$ and $SR_Q$ are multiplied by the carrier signals $SC_I$ and $SC_Q$ at the multipliers 13a and 13b, thereby generating the multiplication derived signals $SM_I$ and $SM_Q$ expressed by the following equations (6a) and (6b), respectively. Furthermore, the multiplication derived signals $SM_I$ and $SM_Q$ are added together at the adder 14, thereby generating the detected signal SD expressed by the following equation (7).

Equation 6

$$\begin{aligned} SM_I \quad &= A^2 \cdot m\cos(pt) \cdot \cos^2(\omega ct) \\ &= A^2 \cdot m\cos(pt) \cdot (1 + \cos(2\,\omega ct))\,/\,2 \qquad \ldots(6a) \end{aligned}$$

$$\begin{aligned} SM_Q \quad &= A^2 \cdot m\cos(pt) \cdot \sin^2(\omega ct) \\ &= A^2 \cdot m\cos(pt) \cdot (1 - \cos(2\,\omega ct))\,/\,2 \qquad \ldots(6b). \end{aligned}$$

Equation 7

$$SD = SM_I + SM_Q = A^2\, m\cos(pt) \qquad \ldots(7).$$

As such, the detected signal SD generated at the detection section 9 has the same waveform as the modulated signal SM with an amplitude of $A^2m$ (see Equation (2)). Accordingly, the detection section 9 can be said to have the detection function.

Furthermore, as can be seen from Equation (7), the detected signal SD is typically characterized by containing no direct current signal component. That is, the invention is typically characterized in that the subtractors 12a and 12b having the carrier elimination function are provided to remove carrier components from signals to be detected or the in-phase component I and the orthogonal component Q. Note that the effects that the detected signal SD contains no direct current components will be described later.

Furthermore, the multiplication derived signals $SM_I$ and $SM_Q$ generated at the multipliers 13a and 13b, which provide the detection function, contain harmonic components in addition to baseband signal components for detection purposes (see Equations (6a) and (6b)). However, this example is typically characterized in that the addition at the adder 14 serves to eliminate the harmonic components and thereby generate the detected signal SD that is free from harmonic components.

A description will now be made to the operation of the automatic gain control section 10.

The carrier signals $SC_I$ and $SC_Q$ are supplied from the band pass filters 11a and 11b to the multipliers 16a and 16b, respectively. Then, the aforementioned summing of squares causes the multipliers 16a and 16b to generate the signals $SS_I$ and $SS_Q$. Next, the addition of the signals $SS_I$ and $SS_Q$ at the adder 17 causes the strength signal SA to be generated and then supplied to the divider 18 that is responsible for the gain adjustment function. Here, the strength signal SA is expressed by the following equation (8) and indicative of only a strength $A^2$.

Equation 8

$$\begin{aligned} SA \quad &= SC_I{}^2 + SCQ^2 = A^2 \cos^2(\omega ct)) + A^2 \sin^2(\omega ct) \\ &= A^2 \qquad \ldots(8). \end{aligned}$$

The divider 18 divides the detected signal SD generated at the detection section 9 by the strength signal SA to generate the gain-controlled detected signal SN expressed by the following equation (9).

Equation 9

$$SN = SD/A^2 = mcos(pt) \qquad\qquad ...(9).$$

This gain-controlled detected signal SN does not contain the carrier amplitude value A of the modulated signal Sin and is thus independent of the strength of a carried signal. Therefore, even in the event of occurrence of variations in carrier signal strength in transmission paths or the like, a detected signal SN which is not affected by such variation is generated.

According to the AM receiver 200 of this example described above, the following effects can be obtained.

The AM receiver 200 allows the band pass filters to provide feedforward and thereby directly regenerate carrier signals without using carrier sync means such as PLLs. It is thus possible to quickly track even an abrupt phase variation of a received AM modulated signal in a transmission path or the like, and thus provide quick responsivity and good trackability to generate detected signals.

Furthermore, the AM receiver 200 is capable of generating the detected signal SD with no undesired direct-current components superimposed thereon. That is, the detection according to the conventional technique required a filter for separating a direct-current component from a detected signal, thereby causing the detected signal to be distorted. However, according to this example, no separation filter is required, thereby making it possible to generate distortion-free detected signals.

Furthermore, the automatic gain control section 10 provides feedforward to directly generate, from a carrier signal, a strength signal required for gain control. Thus, an abrupt strength variation of received modulated signals can be quickly tracked to provide gain control and generate detected signals.

Furthermore, the AM receiver 200 may be implemented in the analog form or in the digital form. In the digital form, the carrier angular frequency $\omega c$ can be lowered when compared with the envelope detection in which sampling is conducted in a high frequency or intermediate frequency band. It is thus possible to reduce the sampling frequency and improve the system efficiency.

Note that this example is designed to employ a superheterodyne front end section. However, the front end section may also be of other than the superheterodyne type.

Furthermore, the AM receiver according to the embodiments and the example described above is implemented with hardware. However, for example, the components subsequent to the front end section may also be implemented with firmware. That is, firmware may be employed in a manner such that computer programs prepared for providing the same function as the circuit arrangement subsequent to the front end section are executed by a microprocessor (MPU) or a digital signal processor (DSP).

## Claims

1. An AM receiver for regenerating a detected signal (SD) from an AM modulated signal (Sin), comprising:

   - orthogonal signal generation means (8) for generating an in-phase component (I) and an orthogonal component (Q) from the AM modulated signal (Sin);
   - first carrier regeneration means (11a) for regenerating an in-phase carrier signal (SCI) from the in-phase component (I);
   - second carrier regeneration means (11b) for regenerating an orthogonal carrier signal (SCQ) from the orthogonal component (Q); and
   - detection processing means (9) for generating a detected signal (SD) from the in-phase component (I) and the orthogonal component (Q) by detecting the in-phase component (I) and the orthogonal component (Q) with the in-phase carrier signal (SCI) and the orthogonal carrier signal (SCQ), respectively, **characterized in that** the detection processing means (9) comprise:
   - first carrier elimination means (12a) for eliminating an in-phase carrier component (SCI) contained in the in-phase component (I) and for generating an in-phase carrier eliminated signal (SRI) as an in-phase detected signal; and
   - second carrier elimination means (12b) for eliminating an orthogonal carrier component (SCQ) contained in the orthogonal component (Q) and for generating an orthogonal carrier eliminated signal (SRQ) as an orthogonal detected signal,

- wherein the detection processing means (9) detect the in-phase detected signal and the orthogonal detected signal with the in-phase carrier signal (SCI) and the orthogonal carrier signal (SCQ), respectively.

2. The AM receiver according to claim 1,
   wherein the detection processing means (9) comprise:

   - first multiplication means (13a) for multiplying the in-phase detected signal (SRI) by the in-phase carrier (SCI);
   - second multiplication means (13b) for multiplying the orthogonal detected signal (SRQ) by the orthogonal carrier (SCQ); and
   - addition means (14) for adding outputs from the first and second multiplication means (13a, 13b) together to thereby generate a combined detected signal (SD).

3. An AM reception method for regenerating a detected signal (SD) from an AM modulated signal (Sin), the method comprising the following steps:

   - an orthogonal signal generation step (8) for generating an in-phase component (I) and an orthogonal component (Q) from the AM modulated signal (Sin);
   - a first carrier regeneration step (11a) for regenerating an in-phase carrier signal (SCI) from the in-phase component (I);
   - a second carrier regeneration step (11b) for regenerating an orthogonal carrier signal (SCQ) from the orthogonal component (Q); and
   - an operational detection step (9) for generating a detected signal (SD) from the in-phase component (I) and the orthogonal component (Q) by detecting the in-phase component (I) and the orthogonal component (Q) with the in-phase carrier signal (SCI) and the orthogonal carrier signal (SCQ), respectively, **characterized by**
   - eliminating an in-phase carrier component (SCI) contained in the in-phase component (I);
   - generating an in-phase carrier eliminated signal (SRI) as an in-phase detected signal;
   - eliminating an orthogonal carrier component (SCQ) contained in the orthogonal component (Q);
   - generating an orthogonal carrier eliminated signal (SRQ) as an orthogonal detected signal; and
   - detecting the in-phase detected signal and the orthogonal detected signal with the in-phase carrier signal (SCI) and the orthogonal carrier signal (SCQ), respectively.

**Patentansprüche**

1. AM-Empfänger zum Regenerieren eines detektierten Signals (SD) aus einem amplitudenmodulierten Signal (Sin), wobei der Empfänger folgendes aufweist:

   - eine Orthogonalsignal-Erzeugungseinrichtung (8) zum Erzeugen einer In-Phase-Komponente (I) und einer Orthogonalkomponente (Q) aus dem amplitudenmodulierten Signal (Sin);
   - eine erste Träger-Regenerierungseinrichtung (11a) zum Regenerieren eines In-Phase-Trägersignals (SCI) aus der In-Phase-Komponente (I);
   - eine zweite Träger-Regenerierungseinrichtung (11b) zum Regenerieren eines Orthogonal-Trägersignals (SCQ) aus der Orthogonalkomponente (Q);

   und

   - eine Detekierungs-Verarbeitungseinrichtung (9) zum Erzeugen eines detektierten Signals aus der In-Phase-Komponente (I) und der Orthogonalkomponente (Q), indem die In-Phase-Komponente (I) und die Orthogonalkomponente (Q) mit dem In-Phase-Trägersignal (SCI) bzw. dem Orthogonalsignal-Trägersignal (SCQ) detektiert wird,

   **dadurch gekennzeichnet,**
   **dass** die Detekierungs-Verarbeitungseinrichtung (9) folgendes aufweist:

   - eine erste Trägerunterdrückungseinrichtung (12a) zum Unterdrücken einer In-Phase-Trägerkomponente (SCI), die in der In-Phase-Komponente (I) enthalten ist, und zum Erzeugen eines trägerunterdrückten In-Phase-Signals (SRI) als ein detektiertes In-Phase-Signal; und

- eine zweite Trägerunterdrückungseinrichtung (12b) zum Unterdrücken einer Orthogonal-Trägerkomponente (SCQ), die in der Orthogonalkomponente (Q) enthalten ist, und zum Erzeugen eines trägerunterdrückten Orthogonalsignals (SRQ) als ein detektiertes Orthogonalsignal,

wobei die Detekierungs-Verarbeitungseinrichtung (9) das detektierte In-Phase-Signal und das detektierte Orthogonalsignal mit dem In-Phase-Trägersignal (SCI) bzw. dem Orthogonal-Trägersignal (SCQ) detektiert.

2. AM-Empfänger nach Anspruch 1,
wobei die Detekierungs-Verarbeitungseinrichtung (9) folgendes aufweist:

- eine erste Multipliziereinrichtung (13a) zum Multiplizieren des detektierten In-Phase-Signals (SRI) mit dem In-Phase-Träger (SCI);
- eine zweite Multipliziereinrichtung (13b) zum Multiplizieren des detektierten Orthogonalsignals (SRQ) mit dem Orthogonal-Träger (SCQ);

und

- eine Addiereinrichtung (14) zum Addieren von Ausgangssignalen der ersten und zweiten Multipliziereinrichtung (13a, 13b) miteinander, um dadurch ein zusammengesetztes Signal (SD) zu erzeugen.

3. AM-Empfangsverfahren zum Regenerieren eines detektierten Signals (SD) aus einem amplitudenmodulierten Signal (Sin),
wobei das Verfahren die folgenden Schritte aufweist:

- einen Orthogonalsignal-Erzeugungsschritt (8) zum Erzeugen einer In-Phase-Komponente (I) und einer Orthogonalkomponente (Q) aus dem amplitudenmodulierten Signal (Sin);
- einen ersten Träger-Regenerierungsschritt (11a) zum Regenerieren eines In-Phase-Trägersignals (SCI) aus der In-Phase-Komponente (I);
- einen zweiten Träger-Regenerierungsschritt (1b) zum Regenerieren eines Orthogonal-Trägersignals (SCQ) aus der Orthogonalkomponente (Q); und
- einen Detekierungs-Verarbeitungsschritt (9) zum Erzeugen eines detektierten Signals aus der In-Phase-Komponente (I) und der Orthogonalkomponente (Q), indem die In-Phase-Komponente (I) und die Orthogonalkomponente (Q) mit dem In-Phase-Trägersignal (SCI) bzw. dem Orthogonalsignal-Trägersignal (SCQ) detektiert wird,

**<u>gekennzeichnet durch</u>**

- Unterdrücken einer In-Phase-Trägerkomponente (SCI), die in der In-Phase-Komponente (I) enthalten ist;
- Erzeugen eines trägerunterdrückten In-Phase-Signals (SRI) als detektiertes In-Phase-Signal;
- Unterdrücken einer Orthogonal-Trägerkomponente (SCQ), die in der Orthogonalkomponente (Q) enthalten ist;
- Erzeugen eines Orthogonal-Trägersignals (SRQ) als detektiertes Orthogonalsignal; und
- Detektierendes detektierten In-Phase-Signals und des detektierten Orthogonalsignals mit dem In-Phase-Trägersignal (SCI) bzw. dem Orthogonal-Trägersignal (SCQ).

## Revendications

1. Récepteur AM pour régénérer un signal détecté (SD) depuis un signal modulé AM (Sin), comprenant:

- un moyen de génération de signal orthogonal (8) pour générer une composante en phase (I) et une composante orthogonale (Q) à partir du signal modulé AM (Sin);
- un premier moyen de régénération de porteuse (11a) pour régénérer un signal de porteuse en phase (SCI) à partir de la composante en phase (I);
- un second moyen de régénération de porteuse (11b) pour régénérer un signal de porteuse orthogonale (SCQ) à partir de la composante orthogonale (Q); et
- un moyen de traitement de détection (9) pour générer un signal détecté (SD) à partir de la composante en phase (I) et de la composante orthogonale (Q) en détectant la composante en phase (I) et la composante orthogonale (Q) avec le signal de porteuse en phase (SCI) et avec le signal de porteuse orthogonale (SCQ),

respectivement,
**<u>caractérisé en ce que</u>**
le moyen de traitement de détection (9) comprend:

un premier moyen d'élimination de porteuse (12a) pour éliminer une composante de porteuse en phase (SCI) contenue dans la composante en phase (I) et pour générer un signal éliminé de porteuse en phase (SRI) à titre de signal détecté en phase; et

- un second moyen d'élimination de porteuse (12b) pour éliminer une composante porteuse orthogonale (SCQ) contenue dans la composante orthogonale (Q) et pour générer un signal éliminé de porteuse orthogonale (SRQ) à titre de signal détecté orthogonal,
- dans lequel le moyen de traitement de détection (9) détecte le signal détecté en phase et le signal détecté orthogonal avec le signal de porteuse en phase (SCI) et avec le signal de porteuse orthogonale (SCQ), respectivement.

2.  Récepteur AM selon la revendication 1,
    dans lequel le moyen de traitement de détection (9) comprend:

- un premier moyen de multiplication (13a) pour multiplier le signal détecté en phase (SRI) par la porteuse en phase (SCI);
- un second moyen de multiplication (13b) pour multiplier le signal détecté orthogonal (SRQ) par la porteuse orthogonale (SCQ); et
- des moyens d'addition (14) pour additionner les sorties provenant du premier et du second moyen de multiplication (13a, 13b) ensemble pour générer ainsi un signal détecté combiné (SD).

3.  Procédé de réception AM pour régénérer un signal détecté (SD) à partir d'un signal modulé AM (Sin), le procédé comprenant les étapes suivantes:

- une étape de génération de signal orthogonal (8) pour générer une composante en phase (I) et une composante orthogonale (Q) à partir du signal modulé AM (Sin);
- une première étape de régénération de porteuse (11a) pour régénérer un signal de porteuse en phase (SCI) à partir de la composante en phase (I);
- une seconde étape de régénération de porteuse (11b) pour régénérer un signal de porteuse orthogonale (SCQ) à partir de la composante orthogonale (Q); et
- une étape de détection opérationnelle (9) pour générer un signal détecté (SD) à partir de la composante en phase (I) et de la composante horizontale (Q) en détectant la composante en phase (I) et la composante orthogonale (Q) avec le signal de porteuse en phase (SCI) et avec le signal de porteuse orthogonale (SCQ), respectivement,
**<u>caractérisé par</u>** les étapes consistant à:
- éliminer une composante de porteuse en phase (SCI) contenue dans la composante en phase (I);
- générer un signal éliminé de porteuse en phase (SRI) à titre de signal détecté en phase;
- éliminer une composante de porteuse orthogonale (SCQ) contenue dans la composante orthogonale (Q);
- générer un signal éliminé de porteuse orthogonale (SRQ) à titre de signal détecté orthogonal; et
- détecter le signal détecté en phase et le signal détecté orthogonal avec le signal de porteuse en phase (SCI) et avec le signal de porteuse orthogonale (SCQ), respectivement.

# FIG.1

ANTENNA

RF AMPLIFIER → FILTER → MIXER → IF FILTER → IF AMPLIFIER → DETECTOR

LOCAL OSCILLATOR

AUTOMATIC GAIN CONTROLLER

PRIOR ART

EP 1 944 872 B1

*FIG.2*

# FIG.3

FIG.4

## FIG.5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0722235 A2

**Non-patent literature cited in the description**

- *NHK Radio Technical Textbook (AM/FM/PCM,* 1993, 201-220